# EUROPEAN PATENT APPLICATION

(11) **EP 4 462 476 A1**
(43) Date of publication of application: **13.11.2024**
(21) Application number: 22928160.5
(22) Date of filing: 25.08.2022
(51) Int. Cl.: H01L 23/31, H01L 21/56, H01L 21/329, H01L 29/47, H01L 29/872, H01L 23/29, H01L 23/28

(54) **SEMICONDUCTOR DEVICE AND MANUFACTURING METHOD THEREFOR**

(30) Priority: 24.02.2022 CN 202210176403
(71) Applicant: Huawei Digital Power Technologies Co., Ltd., Shenzhen, Guangdong 518043 (CN)
(72) Inventor: YU, Yi, Shenzhen, Guangdong 518043 (CN); LIU, Chia Fu, Shenzhen, Guangdong 518043 (CN); WANG, Yuru, Shenzhen, Guangdong 518043 (CN); GAO, Bo, Shenzhen, Guangdong 518043 (CN); TANG, Longgu, Shenzhen, Guangdong 518043 (CN); WANG, Xin, Shenzhen, Guangdong 518043 (CN); ZHAO, Dongguang, Shenzhen, Guangdong 518043 (CN); LUO, Shijin, Shenzhen, Guangdong 518043 (CN)
(74) Representative: Gill Jennings & Every LLP
(86) International application number: PCT/CN2022/114682
(87) International publication number: WO 2023/159894

(57) **Abstract**

Embodiments of this application provide a semiconductor device and a semiconductor device manufacturing method. The semiconductor device includes: a substrate; an epitaxial layer, located on one side of the substrate, where a doped region is formed on a surface that is of the epitaxial layer and that is away from the substrate, and the epitaxial layer includes an active region and a termination region that surrounds the active region; a passivation layer, covering the termination region and on which a window corresponding to the active region is formed; and a metal layer, covering the window and an inner edge that is of the passivation layer and that forms the window, and forming a schottky contact with the active region in the window. By using the solution of embodiments of this application, a structure of the passivation layer is laid underneath the metal layer, so that the passivation layer does not need to envelop the metal layer, thereby reducing a quantity of corners formed on the passivation layer. This can reduce stress exerted on the passivation layer in a temperature change scenario such as a thermal cycle, so that cracking is not prone to occur, thereby preventing device failure caused by moisture intrusion through a crack and improving robustness of the device in a high-temperature and high-moisture environment.

## Description

This application claims priority to Chinese Patent Application No.202210176403.6, filed with the China National Intellectual Property Administration on February 24, 2022 and entitled "SEMICONDUCTOR DEVICE AND SEMICONDUCTOR DEVICE MANUFACTURING METHOD", which is incorporated herein by reference in its entirety.

### TECHNICAL FIELD

This application relates to the field of semiconductor technologies, and in particular, to a semiconductor device and a semiconductor device manufacturing method.

### BACKGROUND

Power electronics is an important technology for electric power conversion and control, of which power semiconductor devices are the core and cornerstone. Owing to its excellent physical and chemical characteristics, silicon carbide (silicon carbide, SiC) can be used to make high temperature and high pressure resistant power semiconductor devices for developing power electronics systems with higher power density and low power consumption at low manufacturing costs.

A power semiconductor device includes an active region and a termination region. The termination region may be used to extend a high electric field in reverse biasing, to increase a breakdown voltage. In addition, to prevent an unfavorable factor caused under an action of moisture intrusion and a high electric field from affecting device reliability, a passivation layer needs to be disposed on the termination region for protection.

In an existing semiconductor device, a structure of a passivation layer has a serious problem of stress concentration, and therefore, is prone to crack due to excessive stress exerted in a temperature change scenario such as a thermal cycle (especially in an extreme thermal cycle condition). As a result, a moisture intrusion path is formed, which causes the semiconductor device to fail, thereby affecting product reliability.

### SUMMARY

Embodiments of this application provide a semiconductor device and a semiconductor device manufacturing method, which can reduce stress exerted on a passivation layer in a temperature change scenario such as a thermal cycle (especially in an extreme thermal cycle condition), so that cracking is not prone to occur. This can prevent device failure caused by moisture intrusion through a crack, thereby improving robustness of the device in a high-temperature and high-moisture environment.

Therefore, embodiments of this application use the following technical solutions:

According to a first aspect, an embodiment of this application provides a semiconductor device. The semiconductor device includes: a substrate; an epitaxial layer, located on one side of the substrate, where a doped region is formed on a surface that is of the epitaxial layer and that is away from the substrate, and the epitaxial layer includes an active region and a termination region that surrounds the active region; a passivation layer, covering the termination region and on which a window corresponding to the active region is formed; and a metal layer, covering the window and an inner edge that is of the passivation layer and that forms the window, and forming a schottky contact with the active region in the window.

In the semiconductor device of this embodiment of this application, the passivation layer is disposed between the metal layer and the epitaxial layer. In other words, a structure of the passivation layer is laid underneath the metal layer. In this way, the passivation layer does not need to envelop an outer edge of the metal layer, thereby reducing a quantity of corners formed on the passivation layer. This can reduce stress exerted on the passivation layer in a temperature change scenario such as a thermal cycle (especially in an extreme thermal cycle condition), so that cracking is not prone to occur, thereby preventing moisture intrusion through a crack and improving robustness of the semiconductor device in a high-temperature and high-moisture environment.

In a possible implementation, the passivation layer includes a first passivation layer, a second passivation layer, and a third passivation layer that are stacked in sequence and disposed in contact with each other, the first passivation layer is located between the epitaxial layer and the second passivation layer, and a material of the second passivation layer is different from both a material of the first passivation layer and a material of the third passivation layer. In other words, in this implementation, the passivation layer may be disposed in a three-layer structure. The material of the second passivation layer is different from both the material of the first passivation layer and the material of the third passivation layer. Therefore, coefficients of thermal expansion thereof are also different. In other words, the structure of the passivation layer may be optimized by using a difference between the coefficients of thermal expansion, to further prevent the passivation layer from cracking, thereby better preventing moisture intrusion.

In a possible implementation, a first window corresponding to the active region is disposed on the first passivation layer, a second window corresponding to the active region is disposed on the second passivation layer, and the second window is located on an outer side of the first window; the third passivation layer includes a first portion located on a side face that is of the second passivation layer and that is away from the first passivation layer, a second portion that covers an inner circumferential wall of the second window, and a third portion that is disposed on the first passivation layer in a stacking manner; and a third window corresponding to the active region is disposed on the third portion of the third passivation layer, and the first window and the third window correspond to and communicate with each other to form the window. In this way, an inner edge that is of the first passivation layer and that forms the first window and an inner edge that is of the third passivation layer and that forms the third window are stacked and in contact, and envelop an inner edge that is of the second passivation layer and that forms the second window.

In a possible implementation, the material of the first passivation layer and the material of the third passivation layer are the same and include silicon oxide; and/or the material of the second passivation layer includes silicon nitride. A CTE value of metal is relatively large, a CTE value of silicon nitride is relatively small, and a CTE value of silicon oxide is in between. Therefore, the third passivation layer is made to completely envelop an inner edge that is of the second passivation layer and that is close to the active region. This on the one hand can mitigate deformation stress exerted on the metal layer in a thermal cycle scenario, and on the other hand can protect the second passivation layer from cracking.

In a possible implementation, a thickness of the third passivation layer is less than a thickness of the first passivation layer and a thickness of the second passivation layer. In other words, in this implementation, the second passivation layer has a specific thickness, and a corner is formed when the third passivation layer envelops the inner edge that is of the second passivation layer and that is close to the active region. Therefore, making the thickness of the third passivation layer less than the thickness of the first passivation layer and the thickness of the second passivation layer can reduce stress exerted when deformation occurs at a position of the corner because of a temperature change, so that cracking is not prone to occur, thereby improving device reliability.

In a possible implementation, the semiconductor device includes a protective layer, covering the passivation layer and an outer edge of the metal layer. In other words, in this implementation, to better protect the semiconductor device, the protective layer may be disposed. For example, the protective layer may be a PI adhesive layer, namely polyimide.

According to a second aspect, an embodiment of this application provides a semiconductor device manufacturing method. The manufacturing method includes: forming a doped region on a surface that is of an epitaxial layer and that is away from a substrate, where the epitaxial layer is located on one side of the substrate and includes an active region and a termination region that surrounds the active region; disposing a passivation layer on the termination region, where the passivation layer has a window, and the window corresponds to the active region; and disposing a metal layer on the window and on an inner edge that is of the passivation layer and that forms the window, where the metal layer forms a schottky contact with the active region in the window.

In a possible implementation, the passivation layer includes a first passivation layer, a second passivation layer, and a third passivation layer, and the disposing a passivation layer on the termination region includes: forming a first dielectric layer and a second dielectric layer in sequence on the epitaxial layer, where a material of the first dielectric layer is different from a material of the second dielectric layer; etching a second window on a portion that is of the second dielectric layer and that corresponds to the active region, to form the second passivation layer; forming a third dielectric layer on the second window and on the second passivation layer, where in the second window, the third dielectric layer covers an inner circumferential wall of the second window and is stacked on and in contact with the first dielectric layer, and the material of the second dielectric layer is different from a material of the third dielectric layer; and etching on the first dielectric layer and the third dielectric layer at a position that is on an inner side of the second window and that corresponds to the active region, which includes: etching a third window on the third dielectric layer to form the third passivation layer, and etching a first window on the first dielectric layer to form the first passivation layer, where the first window and the third window correspond to and communicate with each other to form the window.

In a possible implementation, the first window and the third window are formed by using one etching process.

In a possible implementation, the manufacturing method further includes: disposing a protective layer on the passivation layer and on an outer edge of the metal layer.

Other features and advantages of the present invention are described in detail in the following part of specific embodiments.

### BRIEF DESCRIPTION OF THE DRAWINGS

The following briefly describes the accompanying drawings that need to be used in the descriptions of embodiments or a conventional technology.
FIG. 1A is a schematic diagram of a top-view structure of a semiconductor device;
FIG. 1B is a schematic diagram of a cross-sectional structure along an A-A line of the semiconductor device shown in FIG. 1A;
FIG. 2 is a schematic diagram of a top-view structure of a semiconductor device with a protective layer partially removed according to an embodiment of this application;
FIG. 3 is a schematic diagram of a cross-sectional structure along a B-B line of the semiconductor device shown in FIG. 2;
FIG. 4 is a flowchart of a semiconductor device manufacturing method according to an embodiment of this application;
FIG. 5 is a specific flowchart of Step S402 of the semiconductor device manufacturing method shown in FIG. 4; and
FIG. 6 to FIG. 10 are specific flowcharts of Step S402 of the semiconductor device manufacturing method shown in FIG. 5.

### DETAILED DESCRIPTION

The following describes the technical solutions in embodiments of this application with reference to the accompanying drawings in embodiments of this application.

In descriptions of this application, locations or location relationships indicated by terms "center", "up", "down", "in front of", "behind", "left", "right", "vertical", "horizontal", "top", "bottom", "inside", "outside", and the like are based on locations or location relationships shown in the accompanying drawings, and are merely intended for ease of describing this application and simplifying descriptions, instead of indicating or implying that a mentioned apparatus or component needs to be provided on a specific location or constructed and operated on a specific location, and therefore shall not be understood as limitations on this application.

In the descriptions of this application, it should be noted that, unless otherwise clearly specified and limited, terms "mount", "link", and "connect" should be understood in a broad sense, for example, may be a fixed connection, may be a detachable connection, or may be a butt joint connection or an integrated connection. Persons of ordinary skill in the art can understand specific meanings of the foregoing terms in this application based on specific cases.

The following describes in detail acronyms and abbreviations and key terms used in embodiments of this application:
SBD: schottky barrier diode, schottky barrier diode;
MOSFET: metal-oxide-semiconductor field-effect transistor, metal-oxide-semiconductor field-effect transistor;
PI: polyimide, polyimide;
TC: thermal cycle, thermal cycle;
CTE: coefficient of thermal expansion, coefficient of thermal expansion.

It should be noted that embodiments in this application and the features in embodiments may be mutually combined provided that no conflict arises. The following describes this application in detail with reference to the accompanying drawings by using embodiments.

As a most widely applied SiC power device in the industry, a SiC SBD does not have a minority-carrier storage effect in a switching process. A reverse recovery current of the SiC SBD mainly depends on a junction capacitance of a depletion region, and reverse recovery charge and a reverse recovery loss is very low. Therefore, a switching speed of the SiC SBD is improved, and a switching loss is decreased. This greatly improves a switching frequency in an application circuit, thereby providing almost ideal dynamic performance. SiC SBDs are widely applied in rectifiers, photovoltaic inverters, in-vehicle electric drive systems, and other fields.

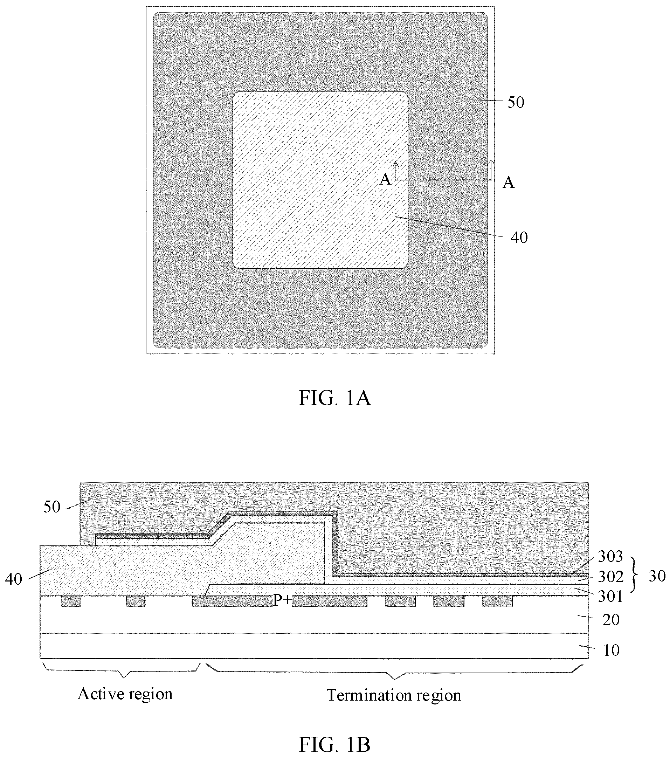

FIG. 1A is a schematic diagram of a top-view structure of a semiconductor device. FIG. 1B is a schematic diagram of a cross-sectional structure along an A-A line of the semiconductor device shown in FIG. 1A. The semiconductor device may be an SBD. It can be understood that the semiconductor device may alternatively be another device, for example, a pin diode. As shown in FIG. 1A and FIG. 1B, the semiconductor device includes a substrate 10, an epitaxial layer 20, a passivation layer 30, a metal layer 40, and a PI adhesive layer 50. The substrate 10 may be Si or SiC. The passivation layer 40 may include silicon oxide or silicon nitride.

As shown in FIG. 1B, the epitaxial layer 20 includes an active region and a termination region. The passivation layer 30 includes a first passivation layer 301, a second passivation layer 302, and a third passivation layer 303. The first passivation layer 301 covers the termination region. The metal layer 40 covers the active region and an inner edge that is of the first passivation layer 301 and that is close to the active region. The second passivation layer 302 and the third passivation layer 303 are stacked in sequence, and cover a portion that is of the first passivation layer 301 and on which the metal layer 40 is not disposed and cover an outer edge of the metal layer 40. In other words, the second passivation layer 302 and the third passivation layer 303 directly cover the metal layer 40. The PI adhesive layer 50 covers the second passivation layer 302, the third passivation layer 303, and the outer edge of the metal layer 40.

Inherent thermal characteristics of layers of materials of the semiconductor device are inconsistent. In a reliability test procedure such as a thermal cycle, CTEs of a molding compound, PI adhesive, and a semiconductor material (such as substrate Si or SiC) do not match, causing shear stress. When a specific quantity of cycles is exceeded, the stress even exceeds a yield strength of a metal material, causing the metal material to deform. Therefore, a material such as silicon oxide or silicon nitride with pool ductility in the second passivation layer 302 and the third passivation layer 303 that cover on the metal layer 40 is prone to crack due to excessive stress exerted at a bending position enveloping the metal layer 40. As a result, a moisture intrusion path is formed, which causes the semiconductor device to fail, thereby affecting product reliability.

In addition, in comparison with an integrated circuit chip, a metal layer on a surface of a power device is relatively thick and relatively large in size, and therefore, deformation is more severe. Compared with an Si material, a SiC material has a larger CTE value difference with a passivation layer material, and a problem of stress concentration is more serious.

In view of this, embodiments of this application provide a semiconductor device and a semiconductor device manufacturing method, where a passivation layer is disposed between a metal layer and an epitaxial layer. In other words, a structure of the passivation layer is laid underneath the metal layer. In this way, the passivation layer does not need to envelop an outer edge of the metal layer, thereby reducing a quantity of corners formed on the passivation layer. This can reduce stress exerted on the passivation layer in a temperature change scenario such as a thermal cycle (especially in an extreme thermal cycle condition), so that cracking is not prone to occur, thereby preventing moisture intrusion through a crack and improving robustness of the semiconductor device in a high-temperature and high-moisture environment. In embodiments of this application, the semiconductor device may be a SiC power device, such as a diode or a MOS transistor. The following uses a SiC SBD power device as an example for description.

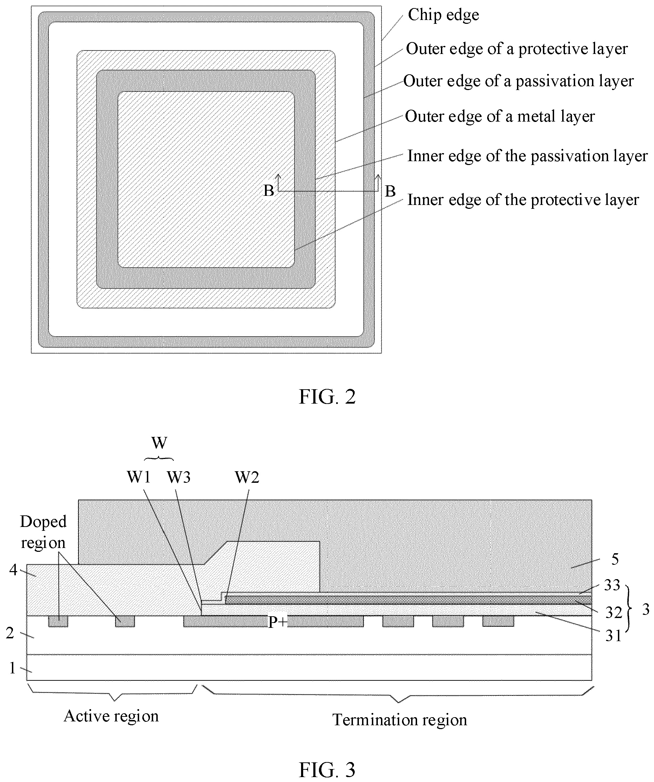

FIG. 2 is a schematic diagram of a top-view structure of a semiconductor device with a protective layer partially removed according to an embodiment of this application. FIG. 3 is a schematic diagram of a cross-sectional structure along a B-B line of the semiconductor device shown in FIG. 2. As shown in FIG. 3, the semiconductor device includes a substrate 1, an epitaxial layer 2, a passivation layer 3, and a metal layer 4. The epitaxial layer 2 is located on one side of the substrate 1. A doped region is formed on a surface that is of the epitaxial layer 2 and that is away from the substrate 1, and the epitaxial layer 2 includes an active region and a termination region that surrounds the active region. For example, the substrate 1 has impurities of a first type, the epitaxial layer 2 has impurities of the first type, and the doped region of the epitaxial layer 2 has impurities of a second type. In addition, a material of the substrate 1 and a material of the epitaxial layer 2 are not limited, and may be, for example, Si or SiC.

The passivation layer 3 covers the termination region, and a window W corresponding to the active region is formed on the passivation layer 3. The metal layer 4 covers the window W and an inner edge that is of the passivation layer 3 and that is close to the active region, namely an inner edge that forms the window W; and forms a schottky contact with the active region in the window W. To be specific, the metal layer 4 is disposed in a stacking manner on the active region and covers the inner edge that is of the passivation layer 3 and that is close to the active region. In other words, the metal layer 4 is bonded with the inner edge that is of the passivation layer 3 and that is close to the active region, and the inner edge of the passivation layer 3 is located between the metal layer 4 and the epitaxial layer 2.

In addition, the semiconductor device may further include a protective layer 5 that covers the passivation layer 3 and an outer edge of the metal layer 4. For example, the protective layer 5 may be a PI adhesive layer, namely polyimide. In FIG. 2, to show a specific structure of the metal layer 4 and the passivation layer 3, the protective layer 5 between the inner edge of the passivation layer 3 and an outer edge of the passivation layer 3 is removed. As shown in FIG. 2, the passivation layer 3 and the PI adhesive layer 5 are circular structures disposed around the metal layer 4.

Referring to FIG. 3 again, to better mitigate moisture intrusion, the passivation layer 3 may include a first passivation layer 31, a second passivation layer 32, and a third passivation layer 33 that are stacked in sequence and disposed in contact with each other. The first passivation layer 31 is located between the epitaxial layer 2 and the second passivation layer 32, and a material of the second passivation layer 32 is different from both a material of the first passivation layer 31 and a material of the third passivation layer 33. For example, the material of the first passivation layer 31 and the material of the third passivation layer 33 are the same and include silicon oxide. The material of the second passivation layer 32 includes silicon nitride. It can be understood that another material may alternatively be selected for the first passivation layer 31, the second passivation layer 32, and the third passivation layer 33 as needed.

A first window W1 corresponding to the active region is disposed on the first passivation layer 31, a second window W2 corresponding to the active region is disposed on the second passivation layer 32, and the second window W2 is located on an outer side of the first window W1. The third passivation layer 33 includes a first portion located on a side face that is of the second passivation layer 32 and that is away from the first passivation layer 31, a second portion that covers an inner circumferential wall of the second window W2, and a third portion that is disposed on the first passivation layer 31 in a stacking manner. A third window W3 corresponding to the active region is disposed on the third portion of the third passivation layer 33, and the first window W1 and the third window W3 correspond to and communicate with each other to form the window W.

In this way, an inner edge that is of the first passivation layer 31 and that forms the first window W1 and an inner edge that is of the third passivation layer 33 and that forms the third window W3 may be stacked and in contact, and envelop an inner edge that is of the second passivation layer 32 and that forms the second window W2. In other words, the inner edge of the first passivation layer 31 and the inner edge of the third passivation layer 33 extend beyond the inner edge of the second passivation layer 32. Extension portions of the first passivation layer 31 and the third passivation layer 33 are stacked and in contact, so that the first passivation layer 31 and the third passivation layer 33 completely envelop the second passivation layer 32. A CTE value of metal is relatively large, a CTE value of silicon nitride is relatively small, and a CTE value of silicon oxide is in between. Therefore, the third passivation layer 33 is made to completely envelop an inner edge that is of the second passivation layer 32 and that is close to the active region. This on the one hand can mitigate deformation stress exerted on the metal layer 4 in a thermal cycle scenario, and on the other hand can protect the second passivation layer 32, so that the second passivation layer 32 is not prone to crack.

In addition, the second window W2 may be etched by using an etching process to form the second passivation layer 32, and the first window W1 and the third window W3 may be etched at the same time by using another etching process to form the first passivation layer 32 and the third passivation layer 33.

Further, for example, as shown in FIG. 3, an outer edge that is of the first passivation layer 31 and that is away from the active region, an outer edge that is of the second passivation layer 32 and that is away from the active region, and an outer edge that is of the third passivation layer 33 and that is away from the active region may be disposed in an aligned manner. For another example, an outer edge that is of the first passivation layer 31 and that is away from the active region and an outer edge that is of the third passivation layer 33 and that is away from the active region are stacked and in contact, and envelop an outer edge that is of the second passivation layer 32 and that is away from the active region. In other words, a structure of the outer edge of the passivation layer 3 may be similar to a structure of the inner edge of the passivation layer 3.

In addition, respective thicknesses of the first passivation layer 31, the second passivation layer 32, and the third passivation layer 33 may be selected as needed. For example, a value range of a thickness H1 of the first passivation layer 31 may be 0.5 µm ≤ H1 ≤ 1.5 µm, a value range of a thickness H2 of the second passivation layer 32 may be 0 µm < H2 ≤ 1 µm, and a value range of a thickness H3 of the third passivation layer 33 may be 0 µm < H3 ≤ 0.5 µm.

Considering that an excessive thickness of the third passivation layer 33 worsens bending deformation of an outer edge that is of the metal layer 4 and that is located above the passivation layer 3, making the outer edge of the metal layer 4 more prone to crack in a thermal cycle scenario, a relatively small thickness may be set for the third passivation layer 33. For example, the thickness of the third passivation layer 33 may be less than the thickness of the first passivation layer 31 and the thickness of the second passivation layer 32. The second passivation layer 32 has a specific thickness, and a corner is formed when the third passivation layer 33 envelops the inner edge that is of the second passivation layer 32 and that is close to the active region. Therefore, making the thickness of the third passivation layer 33 less than the thickness of the first passivation layer 31 and the thickness of the second passivation layer 32 can reduce stress exerted when deformation occurs at a position of the corner because of a temperature change, for example, in a thermal cycle scenario, so that cracking is not prone to occur, thereby improving device reliability.

In the semiconductor device of this embodiment of this application, a phenomenon of stress concentration at a position of a corner on the passivation layer is mitigated, so that cracking is not prone to occur. Specifically, the passivation layer is disposed between the metal layer and the epitaxial layer. In other words, a structure of the passivation layer is laid underneath the metal layer. In this way, the passivation layer does not need to envelop the outer edge of the metal layer, thereby reducing a quantity of corners formed on the passivation layer. This can reduce stress exerted on the passivation layer in a temperature change scenario such as a thermal cycle (especially in an extreme thermal cycle condition). In addition, the structure of the passivation layer is further optimized by using a difference between coefficients of thermal expansion, to prevent the passivation layer from cracking, thereby preventing moisture intrusion through a crack and improving robustness of the semiconductor device in a high-temperature and high-moisture environment.

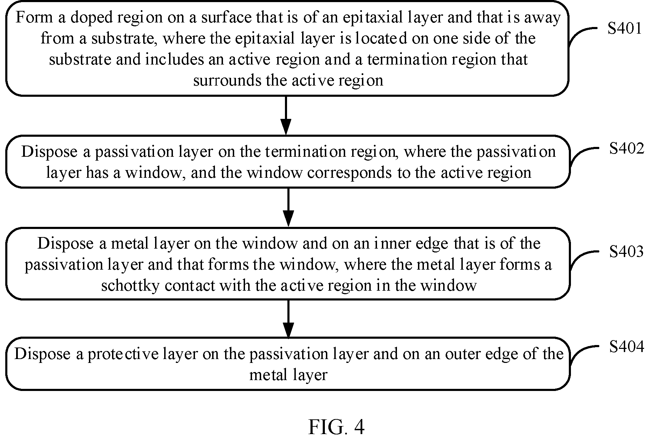

FIG. 4 is a flowchart of a semiconductor device manufacturing method according to an embodiment of this application. As shown in FIG. 4, the manufacturing method includes the following steps:
S401: Form a doped region on a surface that is of an epitaxial layer 2 and that is away from a substrate 1, where the epitaxial layer 2 is located on one side of the substrate 1 and includes an active region and a termination region that surrounds the active region.

Specifically, a doping position on the epitaxial layer 2 may be first determined by using a mask, and then ion injection is performed at the doping position. High temperature annealing is performed after the ion injection, to form the doped region.

S402: Dispose a passivation layer 3 on the termination region, where the passivation layer 3 has a window, and the window corresponds to the active region.

S403: Dispose a metal layer 4 on the window W and on an inner edge that is of the passivation layer 3 and that forms the window W, where the metal layer 4 forms a schottky contact with the active region in the window W.

S404: Dispose a protective layer 5 on the passivation layer 3 and on an outer edge of the metal layer 4.

In this embodiment of this application, a structure of the passivation layer of the semiconductor device is optimized, to prevent the passivation layer from enveloping the metal layer. In this way, the passivation layer has a small quantity of corners. This can reduce stress exerted on the passivation layer in an extreme thermal cycle condition, thereby preventing the passivation layer from cracking and improving robustness of the device in a high-temperature and high-moisture environment.

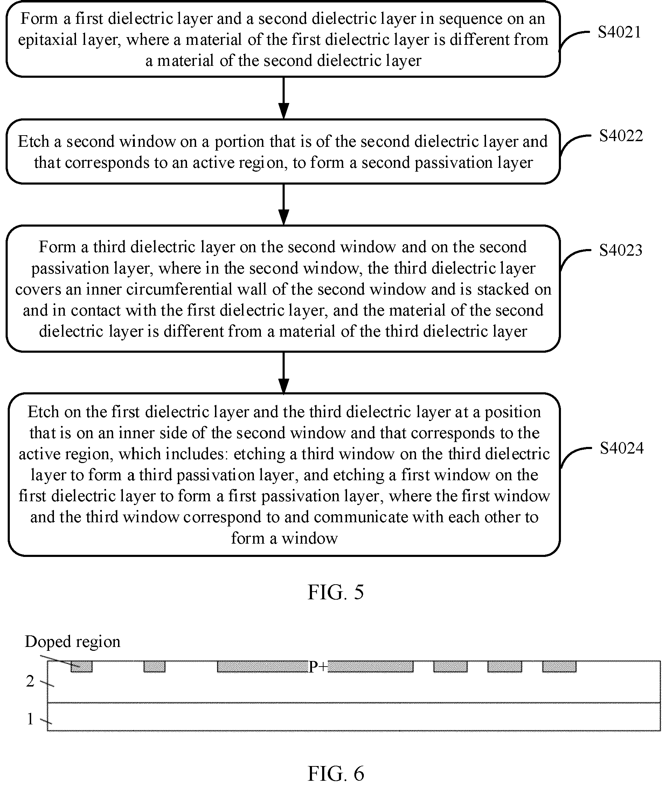

FIG. 5 is a specific flowchart of Step S402 of the semiconductor device manufacturing method shown in FIG. 4. FIG. 6 to FIG. 10 are specific flowcharts of Step S402 of the semiconductor device manufacturing method shown in FIG. 5. The passivation layer 3 may include a first passivation layer 31, a second passivation layer 32, and a third passivation layer 33. In this case, as shown in FIG. 5, S402 may specifically include the following substeps:

S4021. Form a first dielectric layer 3a and a second dielectric layer 3b in sequence on the epitaxial layer 2, where a material of the first dielectric layer 3a is different from a material of the second dielectric layer 3b.

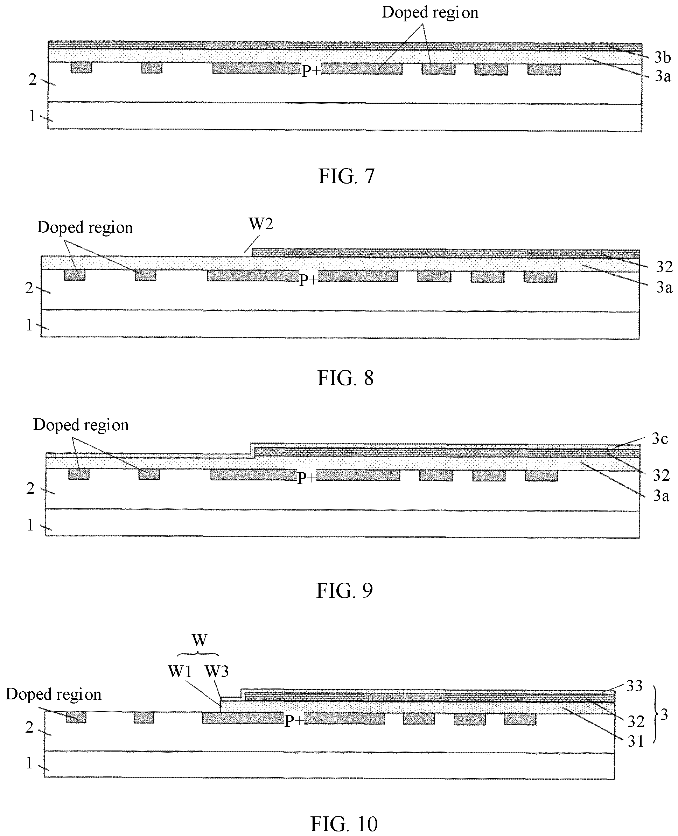

Before S4021 is performed, as shown in FIG. 6, the epitaxial layer 2 is formed on one side of the substrate 1, and the doped region is formed on the surface that is of the epitaxial layer 2 and that is away from the substrate 1. After S4021 is performed, as shown in FIG. 7, the first dielectric layer 3a and the second dielectric layer 3b are formed in sequence on the epitaxial layer 2.

In addition, the first dielectric layer 3a and the second dielectric layer 3b may be formed in sequence on the epitaxial layer 2 through deposition. To be specific, the first dielectric layer 3a may be first formed through deposition, and then the second dielectric layer 3b is formed through deposition.

S4022: Etch a second window W2 on a portion that is of the second dielectric layer 3b and that corresponds to the active region, to form the second passivation layer 32, as shown in FIG. 8.

S4023: Form a third dielectric layer 3c on the second window W2 and on the second passivation layer 32, where in the second window W2, the third dielectric layer 3c covers an inner circumferential wall of the second window W2 and is stacked on and in contact with the first dielectric layer 3a, and the material of the second dielectric layer 3b is different from a material of the third dielectric layer 3c, as shown in FIG. 9.

Specifically, the third dielectric layer 3c may be formed on the first dielectric layer 3a and the second passivation layer 32 through deposition.

S4024: Etch on the first dielectric layer 3a and the third dielectric layer 3c at a position that is on an inner side of the second window W2 and that corresponds to the active region, which includes: etching a third window W3 on the third dielectric layer 3c to form the third passivation layer 33, and etching a first window W1 on the first dielectric layer 3a to form the first passivation layer 31, where the first window W1 and the third window W3 correspond to and communicate with each other to form the window W, as shown in FIG. 10.

In this way, an inner edge that is of the first passivation layer 31 and that is close to the active region (namely an inner edge that forms the first window W1) and an inner edge that is of the third passivation layer 33 and that is close to the active region (namely an inner edge that forms the third window W3) are stacked and in contact, and the inner edge that is of the first passivation layer 31 and that is close to the active region and the inner edge that is of the third passivation layer 33 and that is close to the active region envelop an inner edge that is of the second passivation layer 32 and that is close to the active region.

The material of the first dielectric layer 3a and the material of the second dielectric layer 3b are different. Therefore, different etching processes may be used. Specifically, the second passivation layer 32 may be first formed on the second dielectric layer 3b by using an etching processing, etching is made to stop at the first dielectric layer 3a, and the second passivation layer 32 completely covers the termination region.

In addition, the first dielectric layer 3a and the third dielectric layer 3c may use a same etching process. For example, the materials of the first dielectric layer 3a and the third dielectric layer 3c are the same. Therefore, after the second passivation layer 32 is formed on the second dielectric layer 3b through etching and the third dielectric layer 3c is formed through deposition, the first passivation layer 31 and the third passivation layer 33 may be respectively formed on the first dielectric layer 3a and the third dielectric layer 3c by using the same etching process, and etching is made to stop at the epitaxial layer 2. In other words, the first window W1 and the third window W3 may be formed by using one etching process. The first window W1 is formed through etching on the first passivation layer 31, and the third window W3 is formed through etching on the third passivation layer 33. The first window W1 and the third window W3 correspond to and communicate with each other to form the window W. For example, the first window W1 and the third window W3 are disposed in an aligned manner. In addition, the window W may correspond to the active region of the epitaxial layer 2.

For a passivation structure on a surface of an existing semiconductor power device, in a reliability test procedure such as a thermal cycle, a structure of a passivation layer covering on metal envelops a bending position of the metal, which forms a corner. As a result, a material with poor ductility in the structure of the passivation layer is prone to crack due to excessive stress exerted at a position of the corner, causing device failure.

By using the solution of this embodiment of this application, the passivation layer is laid underneath the metal layer, so that the passivation layer does not need to envelop the outer edge of the metal layer, thereby reducing a quantity of corners formed on the passivation layer. This can reduce stress exerted on the passivation layer in a temperature change scenario such as a thermal cycle (especially in an extreme thermal cycle condition), so that cracking is not prone to occur, thereby preventing device failure caused by moisture intrusion through a crack and improving robustness of the semiconductor device in a high-temperature and high-moisture environment.

The passivation layer may include the first passivation layer, the second passivation layer, and the third passivation layer. The inner edge that is of the second passivation layer and that is close to the active region may be enveloped by the first passivation layer at the bottom and the third passivation layer above. Further, a material of the second passivation layer is different from both a material of the first passivation layer and a material of the third passivation layer, and coefficients of thermal expansion are also different. Therefore, the structure of the passivation layer can be optimized by using a difference between the coefficients of thermal expansion, to prevent the passivation layer from cracking, thereby further improving robustness of the device in a high-temperature and high-moisture environment

It should be noted that the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. A semiconductor device, comprising:
a substrate;
an epitaxial layer, located on one side of the substrate, wherein a doped region is formed on a surface that is of the epitaxial layer and that is away from the substrate, and the epitaxial layer comprises an active region and a termination region that surrounds the active region;
a passivation layer, covering the termination region and on which a window corresponding to the active region is formed; and
a metal layer, covering the window and an inner edge that is of the passivation layer and that forms the window, and forming a schottky contact with the active region in the window.

2. The semiconductor device according to claim 1, wherein the passivation layer comprises a first passivation layer, a second passivation layer, and a third passivation layer that are stacked in sequence and disposed in contact with each other, the first passivation layer is located between the epitaxial layer and the second passivation layer, and a material of the second passivation layer is different from both a material of the first passivation layer and a material of the third passivation layer.

3. The semiconductor device according to claim 2, wherein a first window corresponding to the active region is disposed on the first passivation layer, a second window corresponding to the active region is disposed on the second passivation layer, and the second window is located on an outer side of the first window; the third passivation layer comprises a first portion located on a side face that is of the second passivation layer and that is away from the first passivation layer, a second portion that covers an inner circumferential wall of the second window, and a third portion that is disposed on the first passivation layer in a stacking manner; and a third window corresponding to the active region is disposed on the third portion of the third passivation layer, and the first window and the third window correspond to and communicate with each other to form the window.

4. The semiconductor device according to claim 2 or 3, wherein:
the material of the first passivation layer and the material of the third passivation layer are the same and comprise silicon oxide; and/or
the material of the second passivation layer comprises silicon nitride.

5. The semiconductor device according to any one of claims 2 to 4, wherein a thickness of the third passivation layer is less than a thickness of the first passivation layer and a thickness of the second passivation layer.

6. The semiconductor device according to any one of claims 1 to 5, wherein the semiconductor device comprises:
a protective layer, covering the passivation layer and an outer edge of the metal layer.

7. A semiconductor device manufacturing method, comprising:
forming a doped region on a surface that is of an epitaxial layer and that is away from a substrate, wherein the epitaxial layer is located on one side of the substrate and comprises an active region and a termination region that surrounds the active region;
disposing a passivation layer on the termination region, wherein the passivation layer has a window, and the window corresponds to the active region; and
disposing a metal layer on the window and on an inner edge that is of the passivation layer and that forms the window, wherein the metal layer forms a schottky contact with the active region in the window.

8. The semiconductor device manufacturing method according to claim 7, wherein the passivation layer comprises a first passivation layer, a second passivation layer, and a third passivation layer, and the disposing a passivation layer on the termination region comprises:
forming a first dielectric layer and a second dielectric layer in sequence on the epitaxial layer, wherein a material of the first dielectric layer is different from a material of the second dielectric layer;
etching a second window on a portion that is of the second dielectric layer and that corresponds to the active region, to form the second passivation layer;
forming a third dielectric layer on the second window and on the second passivation layer, wherein in the second window, the third dielectric layer covers an inner circumferential wall of the second window and is stacked on and in contact with the first dielectric layer, and the material of the second dielectric layer is different from a material of the third dielectric layer; and
etching on the first dielectric layer and the third dielectric layer at a position that is on an inner side of the second window and that corresponds to the active region, which comprises: etching a third window on the third dielectric layer to form the third passivation layer, and etching a first window on the first dielectric layer to form the first passivation layer, wherein the first window and the third window correspond to and communicate with each other to form the window.

9. The semiconductor device manufacturing method according to claim 8, wherein the first window and the third window are formed by using one etching process.

10. The semiconductor device manufacturing method according to any one of claims 7 to 9, further comprising:
disposing a protective layer on the passivation layer and on an outer edge of the metal layer.
